# EUROPÄISCHE PATENTANMELDUNG

(11) **EP 2 627 002 A1**
(43) Veröffentlichungstag der Anmeldung: **14.08.2013**
(21) Anmeldenummer: 13153878.7
(22) Anmeldetag: 04.02.2013
(51) Int. Cl.: H03K 17/945, H03K 17/96, H05B 37/02, H05B 39/04

(54) **Elektrisches Steuergerät**

(30) Priorität: 09.02.2012 DE 202012100439 U
(71) Anmelder: GIRA GIERSIEPEN GmbH & Co. KG, 42477 Radevormwald (DE)
(72) Erfinder: Joska, Rolf, 46119 Oberhausen (DE)
(74) Vertreter: Patentanwälte Dr. Solf & Zapf

(57) **Zusammenfassung**

Die vorliegende Erfindung betrifft ein elektrisches Steuergerät (1), wie Schalter, Taster, Dimmer oder dergleichen, mit einem über ein Bedienelement (2) betätigbaren, elektrischen Steuerelement zum Erzeugen eines elektrischen Steuersignals. Das elektrische Steuergerät (1) weist eine Sensoreinrichtung (10) auf mit mindestens einem Näherungssensor (12) zum berührungslosen Erfassen einer Gegenstandsannäherung in einem dem Bedienelement (2) benachbarten Flächenbereich (14) und zum Erzeugen des elektrischen Steuersignals im Falle einer sensorisch erfassten Gegenstandsannäherung.

## Beschreibung

Die vorliegende Erfindung betrifft gemäß dem Oberbegriff des unabhängigen Anspruchs 1 ein elektrisches Steuergerät, wie Schalter, Taster, Dimmer oder dergleichen, mit einem über ein Bedienelement manuell betätigbaren, elektrischen Steuerelement zum Erzeugen eines elektrischen Steuersignals.

Solche Steuergeräte sind in der Elektro-Installationstechnik für Gebäude allgemein bekannt. Bei solchen Elektro-Installationsgeräten handelt es sich häufig um Unterputz-Geräte (UP-Geräte), die mit einem Geräte-Sockel in Installationsdosen installiert werden, wobei die Installationsdosen in Wandflächen eingeputzt oder versenkt in Hohlräumen angeordnet sind. Solche Steuergeräte sind beispielsweise als Schalter, Taster, Tastschalter, Dimmer oder dergleichen ausgebildet, und sie dienen zum Ansteuern, insbesondere zum Ein- und Ausschalten, von beliebigen elektrischen Verbrauchern, wie beispielsweise Leuchten. Dazu wird durch Betätigung des Bedienelementes das elektrische Steuerelement zum Erzeugen eines elektrischen Steuersignals veranlasst. Im einfachsten Fall handelt es sich bei dem Steuerelement um Schaltkontakte, mit denen ein Einschalt- oder Ausschaltsignal durch Schließen oder Öffnen eines Stromkreises erzeugt wird.

Bei einer Installation solcher Steuergeräte auf bzw. in einer Wandfläche wird das Steuergerät in einer bestimmten Norm-Höhe über einem Fußboden montiert, wobei die Norm-Höhe 85 cm oder 105 cm beträgt. Je nach Einsatz kann dies in der Praxis zu niedrig oder zu hoch sein. Vor allem bei Rollstuhlfahrern besteht wegen ihrer relativ niedrigen Sitzhöhe das Problem, dass die Steuergeräte oftmals nicht oder nur mit Mühe erreichbar sind, weil sie zu hoch angeordnet sind. Im umgekehrten Fall kann auch eine zu niedrige Einbauhöhe für große Personen nachteilig sein.

Der vorliegenden Erfindung liegt die Aufgabe zu Grunde, ein Steuergerät der beschriebenen, gattungsgemäßen Art so zu verbessern, dass auch bei Installation in einer bestimmten Einbauhöhe eine komfortablere Nutzung für unterschiedliche Personengruppen möglich ist.

Erfindungsgemäß wird diese Aufgabe durch die Merkmale des unabhängigen Anspruchs 1 gelöst. Vorteilhafte Ausgestaltungen der Erfindung sind in den abhängigen Ansprüchen sowie auch in der folgenden Beschreibung enthalten.

Demnach weist das Steuergerät erfindungsgemäß eine Sensoreinrichtung auf mit mindestens einem Näherungssensor zum berührungslosen Erfassen einer Gegenstandsannäherung in einem dem Bedienelement benachbarten Flächenbereich und zum Erzeugen des elektrischen Steuersignals im Falle einer sensorisch erfassten Gegenstandsannäherung. In bevorzugter Ausgestaltung weist die Sensoreinrichtung zwei Näherungssensoren auf, die derart in zwei diametral gegenüberliegenden Seitenbereichen des Bedienelementes angeordnet sind, dass dem Bedienelement zwei gegenüberliegende, sensorisch überwachte Flächenbereiche benachbart sind.

Die sensorisch überwachten Flächenbereiche bilden demnach zusammen mit dem - wie bisher- manuell betätigbaren Bedienelement einen - insbesondere in vertikaler Richtung - deutlich vergrößerten Bedienbereich, in dem eine sich in den jeweiligen Flächenbereich nähernde Hand sensorisch erkannt und dadurch die jeweilige Steuerfunktion ausgelöst wird. Dabei ist es vorteilhaft, diese Auslösung als Rückmeldung für den Benutzer akustisch und/oder optisch zu signalisieren.

Für die praktische Anwendung ist es vorteilhaft, wenn die vergrößerten BedienFlächenbereiche in der Nachbarschaft des erfindungsgemäßen Steuergerätes durch geeignete Markierungen auf der Wand bzw. auf der jeweiligen Montagefläche kenntlich gemacht werden, beispielsweise durch Farbmarkierungen und/oder Symbole.

Das erfindungsgemäße Steuergerät eignet sich besonders für so genannte barrierefreie Wohnbereiche, insbesondere für Menschen mit Behinderungen. Damit bildet das erfindungsgemäße Steuergerät ein "Altersgerechtes Assistenzsystem für ein gesundes und unabhängiges Leben", kurz "AAL", Stichwort "Ambient Assisted Living".

Anhand der Zeichnung soll die Erfindung im Folgenden beispielhaft genauer erläutert werden. Dabei zeigen:
- Fig. 1: eine Vorderansicht eines erfindungsgemäßen Steuergerätes mit Andeutung der vergrößerten Bedienflächen-Bereiche und
- Fig. 2: eine Seitenansicht in Pfeilrichtung II gemäß Fig. 1 mit einer Gebäudewand und Höhen-Kennzeichnungen.

In den verschiedenen Figuren der Zeichnung sind gleiche Teile stets mit den gleichen Bezugszeichen versehen.

Zu der anschließenden Beschreibung wird ausdrücklich betont, dass die Erfindung nicht auf die Ausführungsbeispiele und dabei nicht auf alle oder mehrere Merkmale von beschriebenen Merkmalskombinationen beschränkt ist, vielmehr kann jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels sowie auch unabhängig von den Merkmalskombinationen und Rückbeziehungen der Ansprüche eine erfinderische Bedeutung haben.

In den Zeichnungsfiguren ist ein erfindungsgemäßes elektrisches Steuergerät 1 beispielhaft als Schalter, Taster oder Tastschalter mit einem manuell betätigbaren Bedienelement 2 dargestellt. Das Bedienelement 2 kann als flächige Schalterwippe oder als Druckflächenelement ausgebildet sein. Zudem ist auch eine Ausbildung als Sensorschalter möglich, wobei das Bedienelement 2 lediglich berührt zu werden braucht, allerdings ist auch eine berührungslose Ausführung über Näherungsschalter möglich.

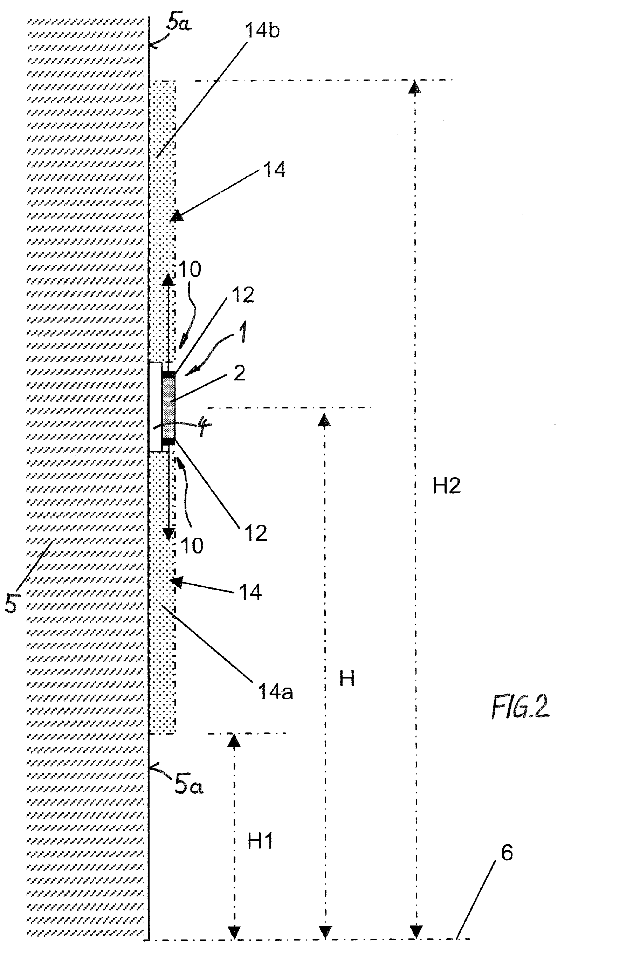

Das Steuergerät 1 weist zudem einen in der Zeichnung nicht erkennbaren Gerätesockel auf, der so in eine Installationsdose eingesetzt wird, dass das Bedienelement 2 - vorzugsweise zusammen mit einem dieses umschließenden Rahmen 4 - auf einer von einer umliegenden Montage- bzw. Wandfläche 5a z. B. einer Gebäudewand 5 definierten Montageebene liegt. Solche Installationsgeräte werden in einer mittleren Höhe H über einer in Fig. 2 durch eine Strichpunktlinie 6 angedeuteten Bodenfläche installiert, wobei die Höhe H normgemäß im Bereich von 85 cm bis 105 cm liegen kann.

Innerhalb des Steuergerätes 1 bzw. seines Gerätesockels ist mindestens ein über das Bedienelement 2 betätigbares Steuerelement zum Erzeugen eines elektrischen Steuersignals angeordnet, wobei es sich z. B. um mindestens einen Schaltkontakt zum Schließen und/oder Öffnen eines Stromkreises handeln kann.

Erfindungsgemäß weist nun das Steuergerät 1 eine integrierte Sensoreinrichtung 10 auf mit mindestens einem Näherungssensor 12 zum berührungslosen Erfassen einer Gegenstandsannäherung in einem dem Bedienelement 2 benachbarten Flächenbereich 14 und zum Erzeugen des elektrischen Steuersignals im Falle einer sensorisch erfassten Gegenstandsannäherung.

In der dargestellten, bevorzugten Ausführung weist die Sensoreinrichtung 10 zwei Näherungssensoren 12 auf, die derart in zwei diametral gegenüberliegenden Seitenbereichen des Bedienelementes 2 angeordnet sind, dass dem Bedienelement 2 zwei gegenüberliegende, sensorisch überwachte Flächenbereiche 14a und 14b benachbart sind. In einer bestimmungsgemäßen Einbaulage des Steuergerätes 1, wie sie in der Zeichnungsfigur veranschaulicht ist, sind die beiden Flächenbereiche 14a, 14b vertikal oberhalb und vertikal unterhalb des Bedienelementes 2 angeordnet. Dadurch wird eine vertikale Bedienbereichsvergrößerung für das Steuergerät 1 erreicht. Die vergrößerten Bedienflächenbereiche können zweckmäßig auf der jeweiligen Montagefläche durch geeignete Markierungen und/oder Symbole kenntlich gemacht werden.

In Fig. 2 ist veranschaulicht, dass eine Bedienbereichsvergrößerung vertikal nach unten bis auf eine untere Höhe H1 und vertikal nach oben bis auf eine obere Höhe H2 erreicht wird. Damit lässt sich der Gesamt-Bedienbereich - je nach der jeweiligen mittleren Höhe H - auf einen Höhenbereich von beispielsweise 60 cm bis 110 cm oder 80 cm bis 130 cm vergrößern.

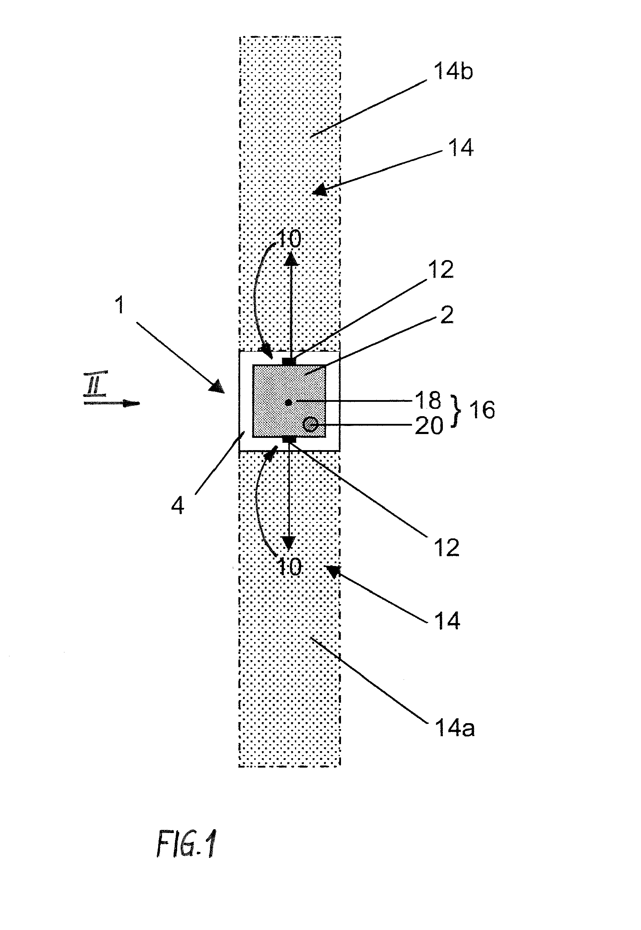

Wie weiterhin in Fig. 1 beispielhaft angedeutet ist, können der oder die Näherungssensoren 12 in dem das Bedienelement 2 umschließenden Rahmen 4 oder gemäß Fig. 2 im Seitenrandbereich des Bedienelementes 2 und über den Rahmen 4 nach vorne vorstehend angeordnet sein, und zwar so, dass jeder Näherungssensor 12 hauptsächlich in Richtung der Montageebene orientiert ist und dadurch Bewegungen von Objekten, insbesondere einer Hand, in den jeweiligen Flächenbereichen 14a, 14b erfasst.

Die Sensoreinrichtung 10 weist zudem eine nicht dargestellte elektronische Auswerteeinheit auf, die bei Erfassung eines Annäherungssignals des jeweiligen Näherungssensors 12 das jeweilige Steuersignal erzeugt.

In weiterer vorteilhafter Ausgestaltung ist eine Signaleinrichtung 16 zum Erzeugen von optischen und/oder akustischen Signalen bei Funktionsauslösungen der Sensoreinrichtung 10 vorgesehen. Diese Signaleinrichtung 16 kann mindestens ein Leuchtelement 18 und/oder mindestens ein akustisches Signalelement 20 aufweisen. Als Leuchtelement 18 ist vor allem eine LED geeignet. Als akustisches Signalelement 20 kann beispielsweise ein Summer oder dergleichen verwendet werden.

In weiterer zweckmäßiger Ausgestaltung kann der bzw. jeder Näherungssensor 12 als Passiv-Infrarot-Sensor (PIR-Sensor), Ultraschall- bzw. Hochfrequenz-Sensor (HF-Sensor) oder als Radar-Sensor ausgebildet sein.

Die Erfindung ist nicht auf die dargestellten und beschriebenen Ausführungsbeispiele beschränkt, sondern umfasst auch alle im Sinne der Erfindung gleichwirkenden Ausführungen. Es wird ausdrücklich betont, dass die Ausführungsbeispiele nicht auf alle Merkmale in Kombination beschränkt sind, vielmehr kann jedes einzelne Teilmerkmal auch losgelöst von allen anderen Teilmerkmalen für sich eine erfinderische Bedeutung haben. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmalen definiert sein. Dies bedeutet, dass grundsätzlich praktisch jedes Einzelmerkmal des Anspruchs 1 weggelassen bzw. durch mindestens ein an anderer Stelle der Anmeldung offenbartes Einzelmerkmal ersetzt werden kann. Insofern ist der Anspruch 1 lediglich als ein erster Formulierungsversuch für eine Erfindung zu verstehen.

## Patentansprüche

1. Elektrisches Steuergerät (1), wie Schalter, Taster, Dimmer oder dergleichen, mit einem über ein Bedienelement (2) betätigbaren, elektrischen Steuerelement zum Erzeugen eines elektrischen Steuersignals,
**gekennzeichnet durch** eine Sensoreinrichtung (10) mit mindestens einem Näherungssensor (12) zum berührungslosen Erfassen einer Gegenstandsannäherung in einem dem Bedienelement (2) benachbarten Flächenbereich (14) und zum Erzeugen des elektrischen Steuersignals im Falle einer sensorisch erfassten Gegenstandsannäherung.

2. Steuergerät nach Anspruch 1,
**dadurch gekennzeichnet, dass** die Sensoreinrichtung (10) zwei Näherungssensoren (12) aufweist, die derart in zwei diametral gegenüberliegenden Seitenbereichen des Bedienelementes (2) angeordnet sind, dass dem Bedienelement (2) zwei gegenüberliegende, sensorisch überwachte Flächenbereiche (14a, 14b) benachbart sind.

3. Steuergerät nach Anspruch 1 oder 2,
**gekennzeichnet durch** eine Ausbildung als Unterputz-Gerät zur teilweise versenkten Montage in einer Montagefläche, wobei der/jeder Flächenbereich (14a, 14b) auf der Montagefläche liegt.

4. Steuergerät nach Anspruch 2 oder 3,
**dadurch gekennzeichnet, dass** die Flächenbereiche (14a, 14b) in einer bestimmungsgemäßen Einbaulage vertikal oberhalb und vertikal unterhalb des Bedienelementes (2) angeordnet sind.

5. Steuergerät nach einem der Ansprüche 1 bis 4,
**dadurch gekennzeichnet, dass** der/jeder Näherungssensor (12) in einem das Bedienelement (2) umschließenden Rahmen (4) oder im Seitenrandbereich des Bedienelementes (2) angeordnet ist.

6. Steuergerät nach einem der Ansprüche 1 bis 5,
**dadurch gekennzeichnet, dass** die Sensoreinrichtung (10) eine elektronische Auswerteeinheit aufweist, die bei Erfassung eines Annäherungssignals des Näherungssensors (12) das Steuersignal erzeugt.

7. Steuergerät nach einem der Ansprüche 1 bis 6,
**dadurch gekennzeichnet, dass** der/jeder Näherungssensor (12) als PIR-Sensor, HF-Sensor oder Radar-Sensor ausgebildet ist.

8. Steuergerät nach einem der Ansprüche 1 bis 7,
**gekennzeichnet durch** eine Signaleinrichtung (16) zum Erzeugen von optischen und/oder akustischen Signalen bei Funktionsauslösungen der Sensoreinrichtung (10),

9. Steuergerät nach Anspruch 8,
**dadurch gekennzeichnet, dass** die Signaleinrichtung (16) mindestens ein Leuchtelement (18) und/oder mindestens ein akustisches Signalelement (20) aufweist.
